# EUROPEAN PATENT SPECIFICATION

(11) **EP 1 874 892 B1**
(45) Date of publication and mention of the grant of the patent: **05.09.2018**
(21) Application number: 06727892.9
(22) Date of filing: 12.04.2006
(51) Int. Cl.: C09K 11/06, H01L 51/30, H01L 51/50, H05B 33/20

(54) **MATRIX MATERIAL FOR ORGANIC ELECTROLUMINESCENT DEVICES**
MATRIXMATERIAL FÜR ORGANISCHE ELEKTROLUMINESZENZGERÄTE
MATERIAU POUR MATRICE DE DEL ORGANIQUE

(30) Priority: 20.04.2005 EP 05103181
(43) Date of publication of application: 09.01.2008
(73) Proprietor: Philips Intellectual Property & Standards GmbH, 20099 Hamburg (DE); Koninklijke Philips N.V., 5656 AE Eindhoven (NL)
(72) Inventor: BOERNER, Herbert, 52066 Aachen (DE)
(74) Representative: Bekkers, Joost J.J.
(86) International application number: PCT/IB2006/051121
(87) International publication number: WO 2006/111886

(56) References cited:
- EP-A- 0 666 298
- EP-A- 1 672 961
- WO-A-2005/056713
- US-A1- 2003 137 239
- PATENT ABSTRACTS OF JAPAN vol. 2003, no. 12, 5 December 2003 (2003-12-05) -& JP 2004 071380 A (KONICA MINOLTA HOLDINGS INC), 4 March 2004 (2004-03-04)

## Description

The invention relates to an electroluminescent device having an organic electroluminescent layer and aromatic matrix materials with high triplet levels.

An organic electroluminescent device (OLED) having a layer structure of a multiplicity of thin layers, which is applied on a substrate, with at least one organic electroluminescent layer (EL layer) to emit light for a multiplicity of applications, for example room lighting, signal lighting or backlight systems for displays, is known. A typical structure comprises at least one transparent electrode, for example of ITO (indium tin oxide), a reflective electrode, for example of metal, and an electroluminescent layer of an organic material arranged between the electrodes. An OLED having an electroluminescent layer of small light-emitting molecules embedded in a hole- or electron-conductive matrix material is also referred to as a SMOLED (small molecule organic light-emitting diode).

The light-emitting molecules are excited by recombination of charge carriers inside the electroluminescent layer, which are injected into the electroluminescent layer as electrons or holes because of a voltage applied to the electrodes. Owing to the spin statistics, 25% of the light-emitting molecules are excited into the singlet state from which they can enter the ground state by emitting light (fluorescence). 75% of the excitation, however, takes place into the lowest-energy triplet state from which radiative transition to the ground state is forbidden, which leads to very long radiative lifetimes. Light emission from the triplet level, which is referred to as phosphorescence, is observed in most materials only if they are cooled to nitrogen temperatures. There are nevertheless some light-emitting materials exhibiting radiative transitions from the triplet state even at room temperature owing to a mixture of singlet and triplet states. Typically, however, the lifetime of the excited triplet state is in the range of a microsecond to a millisecond, and therefore orders of magnitude more than the lifetime of the excited singlet level. During this comparatively long time, the energy may be transferred to neighboring matrix molecules if the triplet levels of the matrix molecules are at an equal energy level or lower. Once the triplet energy has been transferred to the matrix molecules, there is a high probability that it will be lost from the light emission.

Document WO 01/96454 discloses long-chained aromatic matrix molecules suitable for the excitation of light-emitting materials with emission wavelengths in the red, green or blue spectral range. For effective excitation of light-emitting materials by means of energy transfer, the matrix molecules have preferably polarizable substituents and are furthermore distinguished by a large molecular weight of more than 30,000 daltons, in order to avoid crystallization effects during operation of the electroluminescent device. 1 dalton corresponds to 1.66*10⁻²⁷ kg, which is about 1/12 the atomic weight of carbon. 30,000 daltons therefore correspond to the weight of 2500 carbon atoms. The individual molecules are composed of recurring molecule components comprising fluorenes and phenyls. The molecules have a number (not specified in detail) of organic and/or inorganic substituents at positions (not defined in detail) on the molecule components, and the substituents can form bridges between one another.

As is known, the triplet levels of aromatic polymers become shifted to longer wavelengths by concatenation of molecule components. For example, the energy (here expressed by the reciprocal wave number 1/λ) of the triplet level of benzene decreases from 29,500 cm⁻¹ through naphthalene (21,300 cm⁻¹) to anthracene (14,700 cm⁻¹), and for phenyls the triplet level decreases from 22,900 cm⁻¹ for 1,1'-biphenyl through 20,400 cm⁻¹ for p-terphenyl to less than 19,000 cm⁻¹ for p-quaterphenyl, and the same applies to fluorenes. Blue light, however, has wave numbers of between 20,700 cm⁻¹ and 22,300 cm⁻¹. Although the aromatic matrix materials disclosed in WO 01/96454 permit blue light emission from the singlet states of the light-emitting molecules, in the materials described the energy of the excited triplet states of the light-emitting molecules for blue light emission can nevertheless be transferred to the triplet levels of the matrix materials, and therefore released without radiation, which entails a low efficiency of the OLED in the blue spectral range.

In the US 2003/137239, EP 666 298, EP 1 672 961 and JP 2004 071380 several materials, amongst them matrix materials for OLEDs, are known.

It is therefore an object of this invention to provide an organic matrix material having a high triplet energy for efficient blue light emission with at the same time good performance properties for electroluminescent devices.

This object is achieved by a matrix material for an organic electroluminescent device, comprising substituted aromatic molecules for hole and/or electron conduction with at least 2 aromatic molecule components joined to one another via a carbon-carbon single bond, which as individual molecule components respectively have a first triplet level with an excitation energy of more than 23,000 cm⁻¹ and which respectively comprise at least one substituent in an ortho position with respect to the carbon-carbon single bond, the substituents incorporated in the ortho position causing a rotation of neighboring molecule components along the carbon-carbon single bond as a rotation axis owing to their size.

Aromatic molecule components sometimes have an excitation energy of more than 23,000 cm⁻¹, which thus lies above the blue spectral range (20,700 cm⁻¹ and 22,300 cm⁻¹) and therefore the entire visible spectral range. Owing to their crystallization susceptibility or insufficient melting temperature, these molecule components cannot be used directly as a matrix material. Stable thin layers can be produced in combination with at least a second molecule component.

On each molecule component, the matrix molecules according to the invention have at least one substituent in an ortho position with respect to the carbon-carbon single bond which joins neighboring molecule components to one another. The substituents arranged in this way cause a mutual rotation of the neighboring molecule components and therefore substantially decouple the individual p orbitals of the molecule components from one another, which leads to substantial preservation of the electronic properties, in particular the high triplet levels, of the individual molecule components in a larger matrix material according to the invention composed of a plurality of molecule components. The decoupling of the p orbitals is in this case a function of the rotation angle. In order to achieve such a rotation, the substantially chemically neutral substituents must have a suitable space-occupying size.

A matrix material in which the substituted aromatic molecules have a molecular mass of less than 10,000 atomic mass units is preferable in this case, particularly preferably less than 2000 atomic mass units, 1 atomic mass unit (u) corresponding to 1.66*10⁻²⁷ kg (about 1/12 the mass of the carbon atom). The possibility of a large conjugation length of the p orbitals would grow with molecular masses that are too great, which would lead to a reduction of the triplet energy of the substituted aromatic molecule compared to the individual aromatic molecule components. Larger molecular masses would furthermore make it at least very difficult to use vapor deposition techniques for producing the organic layers.

It is preferable that the molecule components of the matrix material for an organic electroluminescent device should comprise materials from the group

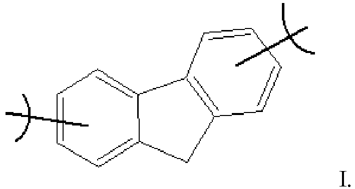

These molecule components are distinguished by particularly high triplet levels of the corresponding sub-molecules, namely 29,500 cm⁻¹ (I), 23,700 cm⁻¹ (II) and 23,400 cm⁻¹ (III).

The number of aromatic molecule components is advantageously less than or equal to 10, preferably less than 6, which then allows sufficient charge transport to excite the light-emitting molecules embedded in the matrix layer, despite the twisted structure of the substituted aromatic molecule and the concomitant substantial decoupling of the p orbitals. With a small number of molecule components, furthermore, excitation energy can also be transported by means of excitons besides charged excitations.

It is particularly preferable for the substituents of the molecule components to be fluorine and/or organic materials, preferably at least partially fluorinated organic materials, comprising linear or branched alkyl, alkenyl, alkynyl or adamantane groups. These space-occupying organic materials prevent the molecule components from rotating back into the planes of neighboring molecule components.

It is particularly preferable for the alkyl chains to have a number of carbon atoms between 2 and 20. These chains are long enough to cause sufficient rotation of neighboring molecule components with simultaneously good substitution properties.

Particularly preferable substituted aromatic molecules consist of one or more molecules from the group 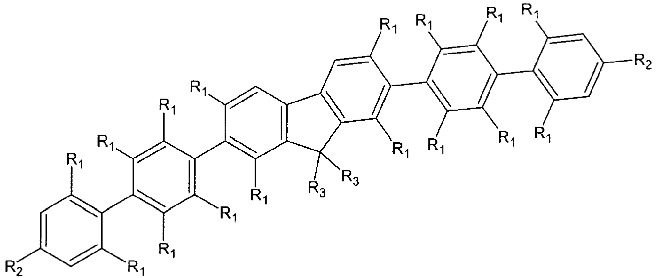 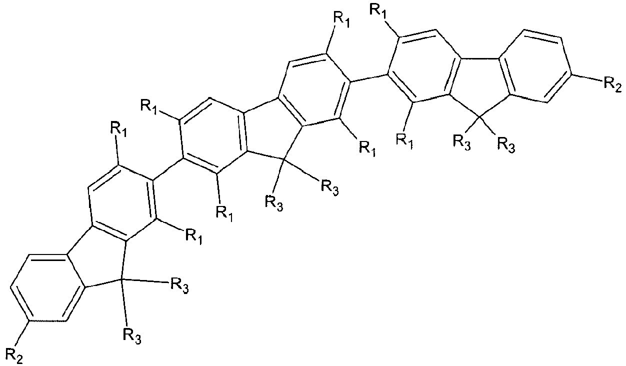 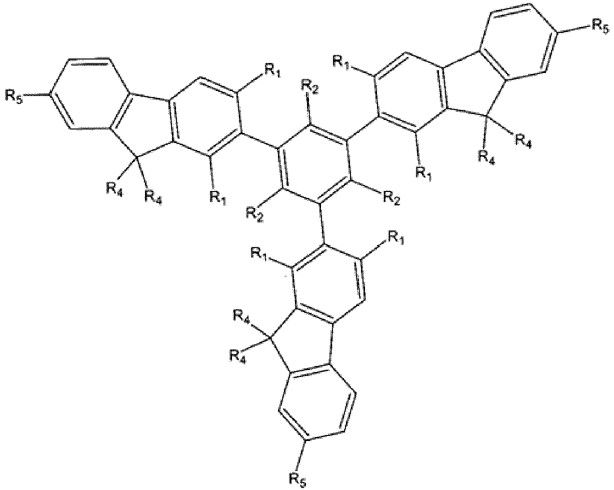 where R1 to R4 are identical or different substituents. Matrix materials which consist predominantly of a p-hexaphenyl core (chain of 6 linked carbon rings) are distinguished by an electron conductivity which is higher than the hole conductivity. R1 to R7 are furthermore used to improve the solubility, reduce crystallization susceptibility, adjust redox potentials (readiness to oxidize or reduce) and to improve the charge transport properties.

It is then advantageous if the rotation between neighboring aromatic molecule components corresponds to an angle of more than 10 degrees, preferably more than 30 degrees. This angle is here the angle between the planes defined by the aromatic rings of the molecule components.

It is particularly preferable for the lower triplet level of the aromatic molecule substituted according to the invention to have an excitation energy of more than 22,500 cm⁻¹, preferably more than 23,000 cm⁻¹, more preferably more than 24,000 cm⁻¹. The excited states in the blue-emitting materials can then enter the ground state only to a very small extent without radiation by means of energy transfer to the matrix material.

The invention furthermore relates to an electroluminescent device having a substrate, at least two electrodes, at least one electroluminescent layer arranged between the electrodes and comprising a matrix material as claimed in claim 1, and a light-emitting material for emission embedded in the matrix material, the lowest triplet level of the matrix material being at a higher energy than the lowest triplet level of the light-emitting material, especially if the light-emitting material emits blue light. Only in this way is it possible to prevent the excited triplet states from transferring their excitation energy to neighboring matrix molecules without radiation. This is very important for an efficient electroluminescent light source, since 75% of the excitation energy goes into excitation of the triplet states owing to the spin statistics.

These and other aspects of the invention are apparent from and will be elucidated with reference to the embodiments described hereinafter.

In the drawing:

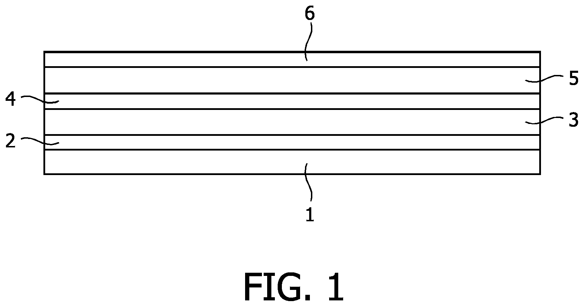

Fig. 1 shows a schematic representation of an electroluminescent device

The electroluminescent device represented in Fig. 1 typically has a substrate 1 and, applied thereon, at least an anode 2, an electroluminescent layer 4 and a cathode 6. In order to improve the efficiency of an electroluminescent device - as shown by Fig. 1 - it may also have a hole-transporting layer 3 between the anode 2 and the electroluminescent layer 4 and an electron-transporting layer 5 between the cathode 6 and the electroluminescent layer 4. If necessary, the layer structure may also be applied in the reverse order. Depending on the intended light exit direction, through the substrate (bottom emitter) or on the other side from the substrate (top emitter), the electrode 2 or 4 is transparent.

In bottom emitters, the substrate 1 is preferably a transparent glass plate or a plastic plate. The plastic plate may, for example, contain polyethylene terephthalate (PET). The anode 2 is preferably transparent and may, for example, contain p-doped silicon, indium-doped tin oxide (ITO) or antimony-doped tin oxide (ATO). The anode 2 preferably contains ITO. The anode 2 is typically not structured but designed as a flat surface. The cathode 6 may, for example, contain a metal such as aluminum, copper, silver or gold, an alloy or n-doped silicon. It may be preferable for the cathode 6 to have two or more conductive layers. It may be particularly preferable for the cathode 6 to contain a first layer of an alkaline earth metal, for example calcium, barium, or LiF and a second layer of aluminum. The cathode 6 may be structured and, for example, contain a multiplicity of parallel strips of the conductive material or conductive materials. Alternatively, the cathode 6 may be unstructured and designed as a flat surface.

The anode 2 is adjoined by a first hole-transporting layer 3 which, in preferred embodiments, consists of a hole-injection layer of for example 4,4',4"-tris-(N-(3-methylphenyl)-N-phenylamino)-triphenylamine (MTDATA) having 1% doping with tetrafluoro-tetracyano-quinodimethane (F4-TCNQ) and a hole-transport layer of for example triarylamines, diarylamines, tristilbeneamines or a mixture of polyethylene dioxythiophene (PDOT) and poly(styrene sulfonate).

A hole-blocking and electron-transporting layer 5 which, for example, may contain tris-(8-hydroxy-quinolinato)-aluminum (Alq₃), 1,3,5-tris-(1-phenyl-1H-benzimidazol-2-yl)benzene (TPBI) or low-electron heterocycles such as 1,3,4-oxadiazoles or 1,2,4-triazoles, is typically arranged between the cathode 6 and the electroluminescent layer 4.

The electroluminescent layer 4 contains an organic matrix material and light-emitting materials embedded therein. Electroluminescent devices having these types of electroluminescent layers 4 are also referred to as a SMOLEDs (small molecule organic light-emitting diode) and are distinguished advantageously with respect to polymers by their possibility of being produced as thin layers by means of vapor deposition. Because of the spin statistics, 25% of the small light-emitting molecules are excited into the singlet state from which they can enter the ground state by emitting light (fluorescence). In 75% of the recombination, however, the excitation takes place into the lowest-energy triplet state from which radiative transition to the ground state is forbidden, which leads to very long radiative lifetimes. Light emission from the triplet level, referred to as phosphorescence, is observed in most materials only if they are cooled to nitrogen temperatures. There are nevertheless some materials which exhibit radiative transitions from the triplet state even at room temperature owing to a mixture of singlet and triplet states. Typically, however, the lifetime of this state is in the range of a microsecond to a millisecond, and therefore very much longer than the transitions from the singlet level. During this comparatively long time, the energy may be transferred to neighboring matrix molecules either if their triplet level is at a lower energy or, in the case of higher triplet levels, if a transition is possible by means of thermal activation. Once the triplet energy has been transferred to other molecules, for example matrix molecules, there is a high probability that it will be lost from the light emission. In order to virtually preclude energy transfer at room temperature, the triplet state of the neighboring matrix molecules should be about 1000-2000 wave numbers above that of the light-emitting molecule. This condition is easy to fulfill for green or red triplet emitters, but it is a difficult requirement for blue triplet emitters since the triplet level of the emitter molecules is from 21,000 cm⁻¹ to 22,000 cm⁻¹ for emission in the blue spectral range.

Without substituents, an increasing molecule size entails a decreasing excitation energy of the triplet level of a matrix molecule, as shown with reference to benzene and the corresponding longer-chained structures a) and b):
a) 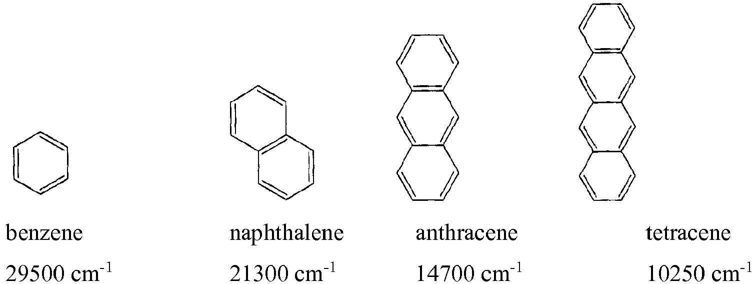
b)

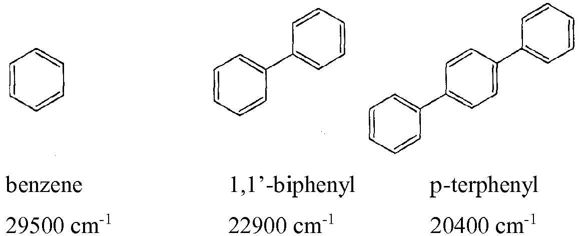

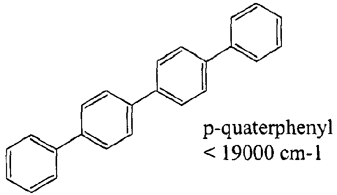

The triplet level decreases from 29,500 cm⁻¹ to 10,250 cm⁻¹ in the sequence benzene → naphthalene → anthracene → tetracene, and the triplet level decreases from 29,500 cm⁻¹ to below 19,000 cm⁻¹ in the sequence benzene → biphenyl → terphenyl → quaterphenyl. The conjugation length of the p orbitals in the molecule increases as the molecule size increases, which, without further measures such as the incorporation of suitable substituents, leads to an energy reduction of the triplet level of the overall molecule compared to the triplet level of the individual molecule component benzene.

Besides triphenylamine with a triplet energy of 24,500 cm⁻¹, the preferred aromatic molecules are benzene, fluorene and triphenylene with the following triplet energies:

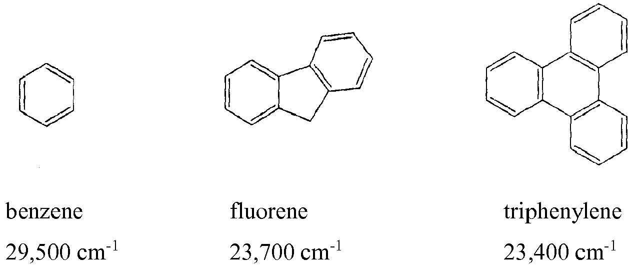

These small molecules, however, are unsuitable as a matrix material because of the high crystallization susceptibility or the insufficient melting or glass transition temperature. From the molecule components benzene, triphenylamine, fluorene and/or triphenylene, in combination with at least a second molecule component from the same group coupled by a carbon-carbon single bond, matrix materials in accordance with the invention can be produced with masses of less than 10,000 atomic mass units, preferably less than 2,000 atomic mass units, when at least one substituent of suitable size is incorporated on each molecule component in an ortho position with respect to the carbon-carbon single bond of neighboring molecule components, so that forced mutual rotation of the neighboring molecule components causes decoupling of the individual p orbitals of the molecule components from one another, as shown in the two subsequent 3D representations of an example of a carbon-carbon single bond between two molecule components (with CH₃ substituents incorporated in ortho position on one side (a) and on both sides (b).
a) 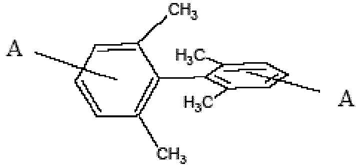
b)

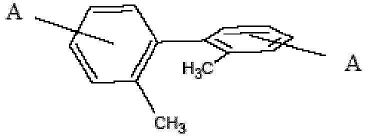

The substituents A denote further molecule components bonded together by a carbon-carbon single bond and/or further substituents. This 3D representation clearly shows the rotation of neighboring molecule components along the carbon-carbon single bond caused by the CH₃ substituents which are each incorporated in ortho position with respect thereto. In this connection, for the existence of mutual rotation of neighboring molecule components it is insignificant whether the substituents (in ortho position) of the two molecule components are incorporated on the same side or opposite sides of the carbon-carbon single bond. To bring about a rotation about a large angle, however, it is advantageous if the substituents of the two neighboring molecule components are incorporated on the same side with respect to the carbon-carbon single bond, as shown in (a). It is alternatively possible however that in each case 2 substituents per molecule component are incorporated in ortho position with respect to the carbon-carbon single bond, as shown in (b). This achieves substantial preservation of the electronic properties, in particular the high triplet levels, of the respective molecule components in a larger substituted aromatic molecule composed of a plurality of molecule components.

Despite the twisted structure and the concomitant substantial decoupling of the p orbitals of the molecule components, the small molecule size compared to polymers allows sufficient charge transport to excite the embedded light-emitting molecules. For effective charge excitation of the light-emitting molecules, the matrix molecules according to the invention should not contain more than 10 molecule components. Molecules having no more than 6 molecule components can also transport exciton energies effectively to the light-emitting materials in addition to the charged excitations.

Thermal vapor deposition represents a conventional layer production technique for SMOLEDs, in particular for molecules having a molecular mass of less than 10,000 atomic mass units, preferably less than 2,000 atomic mass units, since it is easy to control and generates homogeneous and smooth layers.

The following aromatic molecule 1 (not part of the present invention) and embodiments 2 to 3 of aromatic molecules substituted according to the invention are molecules having a p-hexaphenyl core:
1) 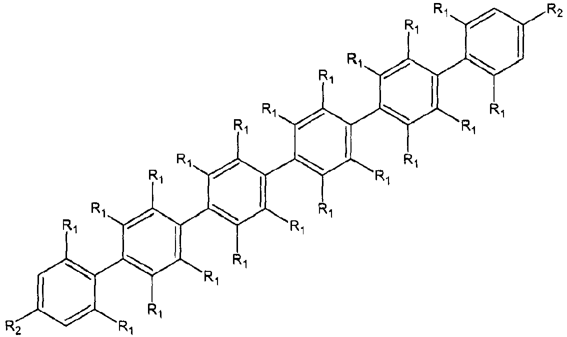
2) 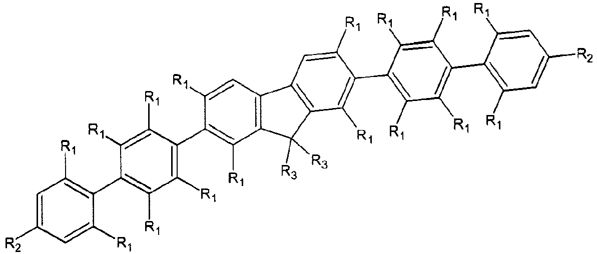
3)

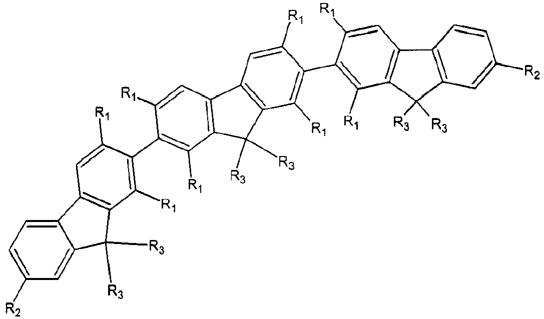

Here, either 6 phenyl rings (aromatic molecule 1) or three fluorene units (embodiment 2) may be joined while being rotated. A combination of aromatic molecule 1 and embodiment 2 is shown in embodiment 3, where a central fluorene unit is joined respectively to 2 phenyl units. In this case, R1 are substituents of suitable size to achieve permanent rotation of the individual neighboring molecule components along the carbon-carbon single bond as a rotation axis. The substituents R2 and R3 may be various organic and/or inorganic materials. For better charge transport properties between the molecules, for example, triphenyl units may be attached terminally for R2 on one or both sides.

Organic materials in particular, preferably at least partially fluorinated organic materials, comprising linear or branched alkyl, alkenyl, alkynyl and/or adamantane groups with a number of carbon atoms between 2 and 20, are suitable as space-occupying substituents R1 which can cause a mutual rotation of the molecule components by their ortho position with respect to the molecule component-joining carbon-carbon single bond. The reference R1 for the substituents according to the invention, consistently selected for all the molecule components, refers only to the similar rotating effect for all molecule components. The materials for R1 may readily differ within a matrix molecule.

Molecules having a phenyl core are shown in the following molecule 4 (not part of the present invention) and embodiment 5 of the matrix materials according to the invention:
4)

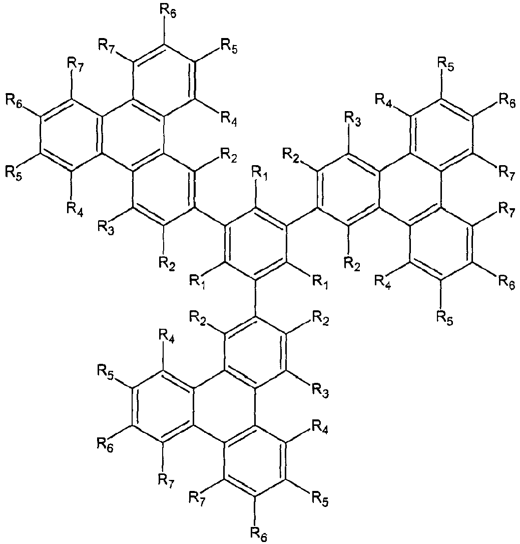

In molecule 4, three triphenyl units are attached in positions 1, 3 and 5 on a central phenyl ring. Here, a rotation with respect to the central phenyl ring can be effected by the substituents R1 and R2 with the aforementioned materials for R1. The substituents R1 and R2 may in this case be identical or different. The substituents R1 on different molecule components may likewise be identical or different. The materials used as substituents R3 to R7 may, for example, be selected suitably in order to improve the solubility, to reduce the crystallization susceptibility or to adjust the redox potentials.

Embodiment 5 shows the coupling of three fluorene units in positions 1, 3 and 5 on a central phenyl ring. Here, a rotation with respect to the central phenyl ring can be effected by the substituents R1 and R2 with the aforementioned materials for R1. The substituents R1 and R2 may in this case be identical or different. The substituents R1 on different molecule components may likewise be identical or different. The materials used as substituents R4 and R5 may, for example, be selected suitably in order to improve the solubility, to reduce the crystallization susceptibility or to adjust the redox potentials.
5)

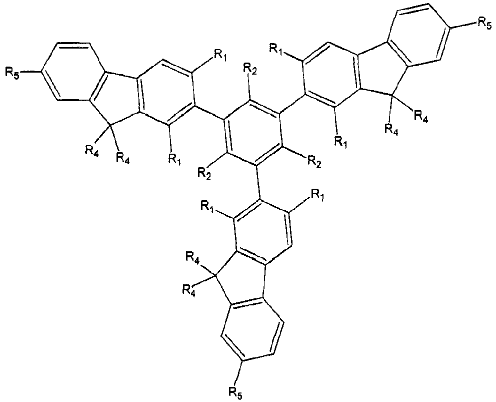

Embodiment of an electroluminescent device according to the invention:
- glass substrate having a 150 nm thick anode of indium tin oxide (ITO)
- MTDATA hole injection layer with 1% F4-TCNQ, thickness 400 nm
- MTDATA hole transport layer, undoped, thickness 100 nm
- emission layer of matrix molecules according to the invention, for example p-hexaphenyl substituted according to the invention, with 9 wt.% light-emitting materials, thickness 150 nm
- TPBI hole-barrier and electron-transport layer, thickness 500 nm
- LiF electron-injection layer, thickness 1 nm
- aluminum cathode, thickness 70 nm

The aforementioned hole barrier layer may be omitted in a preferred embodiment of the electroluminescent device, having matrix materials with an electron mobility which is higher than the hole mobility, which simplifies the production process, p-Hexaphenyl substituted according to the invention is an example of such matrix materials.

The methods for producing the aromatic molecules substituted according to the invention are prior art and therefore known to the person skilled in the art.

The embodiments which have been mentioned represent only a small number of the possible matrix molecules according to the invention, and should not be interpreted as restricting the patent claims to these examples. Alternative embodiments, which are likewise covered by the protective scope of the patent claims, are also possible for the person skilled in the art.

## Claims

1. A matrix material for an organic electroluminescent device, comprising substituted aromatic molecules for hole and/or electron conduction with at least 2 aromatic molecule components joined to one another via a carbon-carbon single bond, which as individual molecule components respectively have a first triplet level with an excitation energy of more than 23,000 cm⁻¹ and which respectively comprise at least one substituent in an ortho position with respect to the carbon-carbon single bond, the substituents incorporated in the ortho position causing a rotation of neighboring molecule components along the carbon-carbon single bond as a rotation axis owing to their size, whereby the aromatic molecule components comprise at least one material from the group

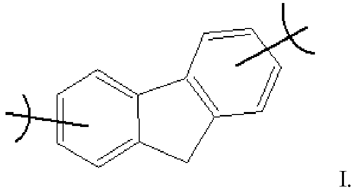

2. A matrix material for an organic electroluminescent device as claimed in claim 1, **characterized in that** the number of aromatic molecule components is less than or equal to 10, preferably less than or equal to 6.

3. A matrix material for an organic electroluminescent device as claimed in any one of the preceding claims, **characterized in that** the substituents are fluorine and/or organic materials, preferably at least partially fluorinated organic materials, comprising alkyl, alkenyl, alkynyl or adamantane groups.

4. A matrix material for an organic electroluminescent device as claimed in claim 3, **characterized in that** the substituents have between 2 and 20 carbon atoms.

5. A matrix material for an organic electroluminescent device as claimed in any one of the preceding claims, **characterized in that** the substituted aromatic molecules consist of one or more molecules from the group: 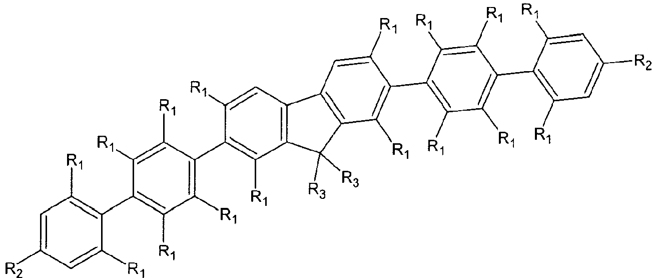 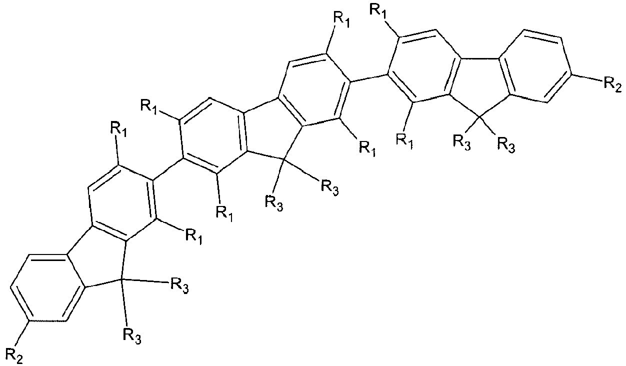 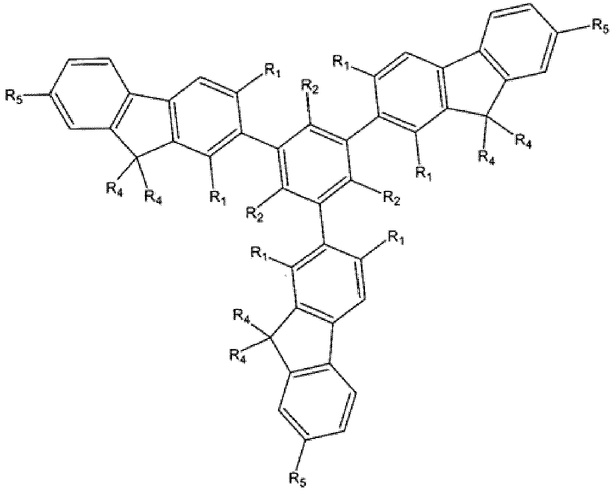 where R1 to R4 comprise identical or different substituents and/or molecule components.

6. A matrix material for an organic electroluminescent device as claimed in any one of the preceding claims, **characterized in that** the rotation between neighboring aromatic molecule components corresponds to an angle of more than 10 degrees, preferably more than 30 degrees.

7. A matrix material for an organic electroluminescent device as claimed in any one of the preceding claims, **characterized in that** the substituted aromatic molecule has a lower triplet level with an excitation energy of more than 22,500 cm⁻¹.

8. An electroluminescent device having a substrate, at least two electrodes, at least one electroluminescent layer arranged between the electrodes and comprising a matrix material as claimed in claim 1, and a light-emitting material embedded in the matrix material, the first triplet level of the matrix material being at a higher energy than the first triplet level of the light-emitting material.

9. An electroluminescent device as claimed in claim 8, **characterized in that** the light-emitting material emits blue light.

## Patentansprüche

1. Matrixmaterial für ein organisches Elektrolumineszenzgerät, welches substituierte aromatische Moleküle für Defekt- und/oder Elektronenleitung mit zumindest 2 über eine Kohlenstoff-Kohlenstoff-Einfachbindung aneinander gefügte aromatischen Molekülkomponenten umfasst, welche als individuelle Molekülkomponenten jeweils eine erste Triplettstufe mit einer Anregungsenergie von mehr als 23.000 cm⁻¹ umfassen und welche jeweils zumindest einen Substituenten in einer Orthostellung in Bezug auf die Kohlenstoff-Kohlenstoff-Einfachbindung umfassen, wobei die in der Orthostellung inkorporierten Substituenten aufgrund ihrer Größe eine Rotation von benachbarten Molekülkomponenten entlang der Kohlenstoff-Kohlenstoff-Einfachbindung als einer Rotationsachse verursachen, wobei die aromatischen Molekülkomponenten zumindest ein Material aus der folgenden Gruppe umfassen

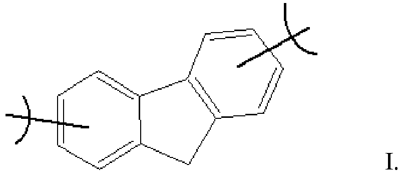

2. Matrixmaterial für ein organisches Elektrolumineszenzgerät nach Anspruch 1, **dadurch gekennzeichnet, dass** die Zahl der aromatischen Molekülkomponenten kleiner als oder gleich 10, vorzugsweise kleiner als oder gleich 6 ist.

3. Matrixmaterial für ein organisches Elektrolumineszenzgerät nach einem der vorstehenden Ansprüche, **dadurch gekennzeichnet, dass** die Substituenten Fluor und/oder organische Materialien sind, vorzugsweise zumindest teilweise fluorierte organische Materialien, welche Alkyl-, Alkenyl-, Alkinyl- oder Adamantangruppen umfassen.

4. Matrixmaterial für ein organisches Elektrolumineszenzgerät nach Anspruch 3, **dadurch gekennzeichnet, dass** die Substituenten zwischen 2 und 20 Kohlenstoffatome aufweisen.

5. Matrixmaterial für ein organisches Elektrolumineszenzgerät nach einem der vorstehenden Ansprüche, **dadurch gekennzeichnet, dass** die substituierten aromatischen Moleküle aus einem oder mehreren Molekül aus der folgenden Gruppe bestehen: 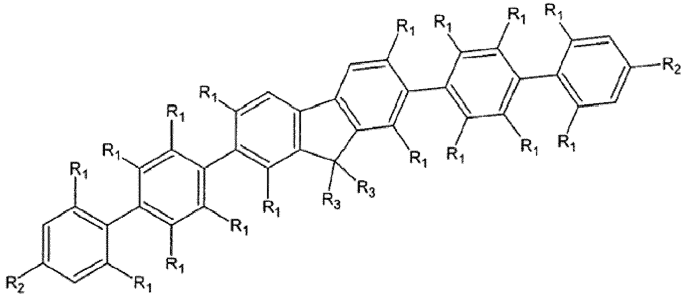 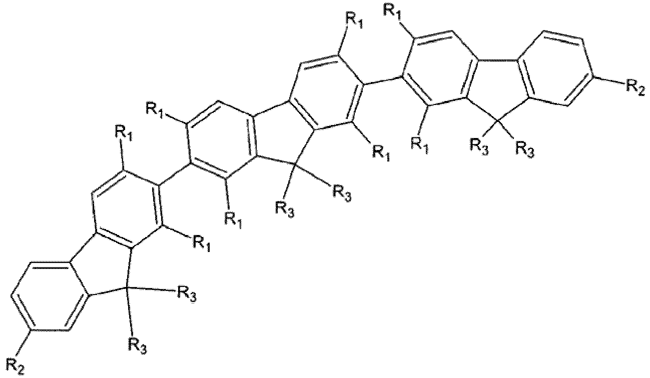 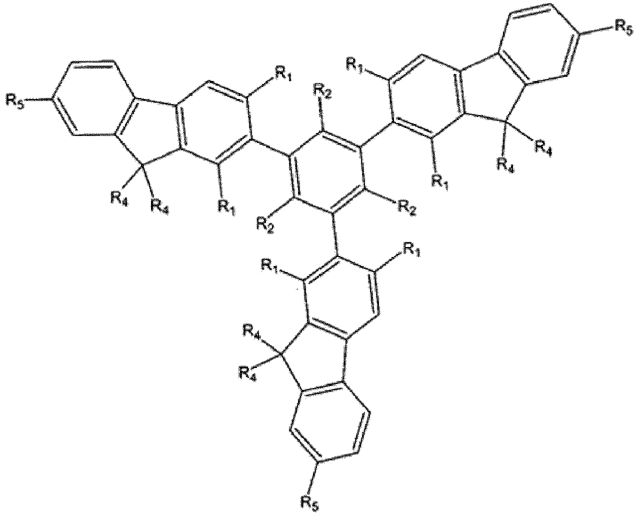 wobei R1 bis R4 identische oder unterschiedliche Substituenten und/oder Molekülkomponenten umfassen.

6. Matrixmaterial für ein organisches Elektrolumineszenzgerät nach einem der vorstehenden Ansprüche, **dadurch gekennzeichnet, dass** die Rotation zwischen benachbarten aromatischen Molekülkomponenten einem Winkel von mehr als 10 Grad, vorzugsweise mehr als 30 Grad, entspricht.

7. Matrixmaterial für ein organisches Elektrolumineszenzgerät nach einem der vorstehenden Ansprüche, **dadurch gekennzeichnet, dass** das substituierte aromatische Moleküle eine niedrigere Triplettstufe mit einer Anregungsenergie von mehr als 22.500 cm⁻¹ aufweist.

8. Elektrolumineszenzgerät mit einem Substrat, zumindest zwei Elektroden, zumindest einer Elektrolumineszenzschicht, welche zwischen den Elektroden angeordnet ist und ein Matrixmaterial nach Anspruch 1 umfasst, und einem lichtemittierenden Material, welches in dem Matrixmaterial eingebettet ist, wobei die erste Triplettstufe des Matrixmaterials eine höhere Energie aufweist als die erste Triplettstufe des lichtemittierenden Materials.

9. Elektrolumineszenzgerät nach Anspruch 8, **dadurch gekennzeichnet, dass** das lichtemittierende Material blaues Licht emittiert.

## Revendications

1. Matériau de matrice pour un dispositif électroluminescent organique, comprenant des molécules aromatiques substituées pour la conduction par trous et/ou électrons avec au moins 2 composants moléculaires aromatiques liés à un autre par l'intermédiaire d'une liaison simple carbone-carbone, lesquels en tant que composants moléculaires individuels ont respectivement un premier niveau de triplet avec une énergie d'excitation de plus de 23 000 cm⁻¹ et qui comprennent respectivement au moins un substituant en une position ortho par rapport à la liaison simple carbone-carbone, les substituants incorporés en position ortho provoquant une rotation des composants moléculaires voisins le long de la liaison simple carbone-carbone en tant qu'axe de rotation en raison de leur taille, moyennant quoi les composants moléculaires aromatiques comprennent au moins un matériau parmi le groupe

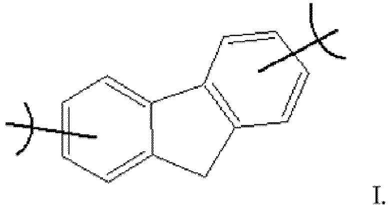

2. Matériau de matrice pour un dispositif électroluminescent organique selon la revendication 1, **caractérisé en ce que** le nombre de composants moléculaires aromatiques est inférieur ou égal à 10, de préférence inférieur ou égal à 6.

3. Matériau de matrice pour un dispositif électroluminescent organique selon l'une quelconque des revendications précédentes, **caractérisé en ce que** les substituants sont des matériaux de fluor et/ou organiques, de préférence des matériaux organiques partiellement fluorés, comprenant des groupes alkyle, alcényle, alcynyle ou adamantane.

4. Matériau de matrice pour un dispositif électroluminescent organique selon la revendication 3, **caractérisé en ce que** les substituants ont entre 2 et 20 atomes de carbone.

5. Matériau de matrice pour un dispositif électroluminescent organique selon l'une quelconque des revendications précédentes, **caractérisé en ce que** les molécules aromatiques substituées sont constituées d'une ou plusieurs molécules parmi le groupe : 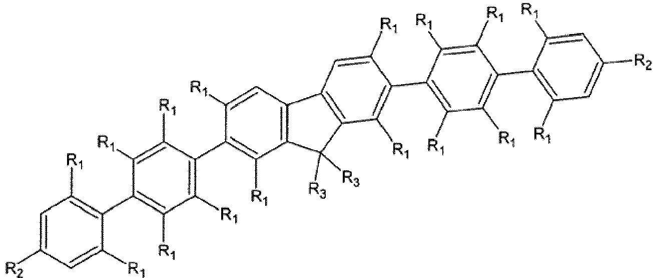 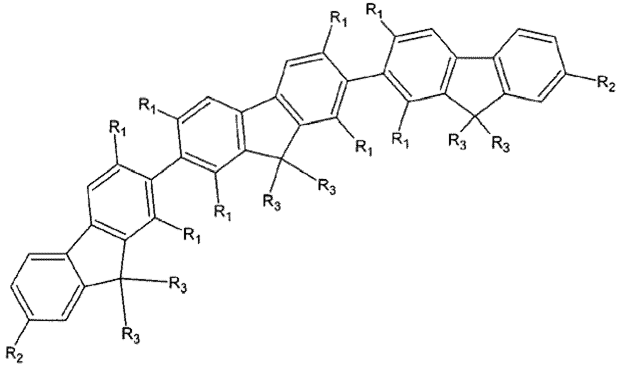 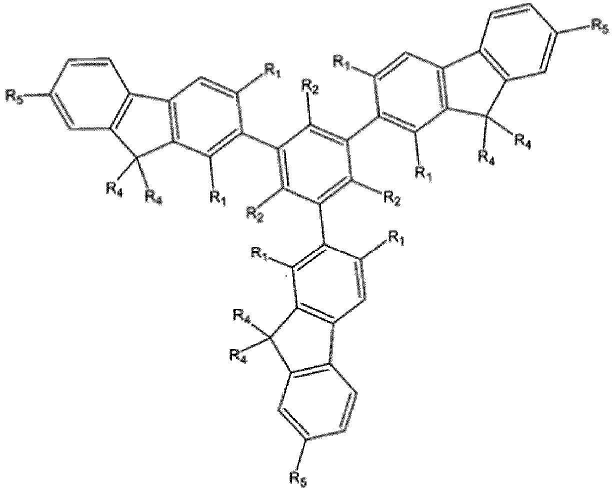 où R1 à R4 comprennent des substituants identiques ou différents et/ou des composants moléculaires.

6. Matériau de matrice pour un dispositif électroluminescent organique selon l'une quelconque des revendications précédentes, **caractérisé en ce que** la rotation entre des composants moléculaires aromatiques voisins correspond à un angle de plus de 10 degrés, de préférence de plus de 30 degrés.

7. Matériau de matrice pour un dispositif électroluminescent organique selon l'une quelconque des revendications précédentes, **caractérisé en ce que** la molécule aromatique substitué à un niveau de triplet inférieur avec une énergie d'excitation de plus de 22 500 cm⁻¹.

8. Dispositif électroluminescent ayant un substrat, au moins deux électrodes, au moins une couche électroluminescente agencée entre les électrodes et comprenant un matériau de matrice selon la revendication 1, et un matériau émettant de la lumière intégrée dans le matériau de matrice, le premier niveau de triplet du matériau de matrice présentant une énergie plus élevée que le premier niveau de triplet du matériau émettant de la lumière.

9. Dispositif électroluminescent selon la revendication 8, **caractérisé en ce que** le matériau émettant de la lumière émet une lumière bleue.
